(19) Europäisches Patentamt
European Patent Office
Office européen des brevets

(11) EP 0 520 265 B1

(12) # EUROPÄISCHE PATENTSCHRIFT

(45) Veröffentlichungstag und Bekanntmachung des Hinweises auf die Patenterteilung:
**17.11.1999 Patentblatt 1999/46**

(51) Int Cl.[6]: **G03F 7/039**, G03F 7/004

(21) Anmeldenummer: **92109980.0**

(22) Anmeldetag: **13.06.1992**

(54) **Positiv arbeitendes strahlungsempfindliches Gemisch mit Disulfonsäurespendern**

Positive working radiation-sensitive composition with disulfone acid generators

Composition sensible aux rayonnements travaillant en positif à générateurs d'acide disulfoniques

(84) Benannte Vertragsstaaten:
**BE DE FR GB IT NL**

(30) Priorität: **27.06.1991 DE 4121199**

(43) Veröffentlichungstag der Anmeldung:
**30.12.1992 Patentblatt 1992/53**

(73) Patentinhaber: **BASF Aktiengesellschaft**
**67063 Ludwigshafen (DE)**

(72) Erfinder:
- **Schwalm, Reinhold, Dr.**
  **W-6706 Wachenheim (DE)**
- **Binder, Horst**
  **W-6840 Lampertheim (DE)**
- **Funhoff, Dirk, Dr.**
  **W-6900 Heidelberg (DE)**
- **Roser, Joachim, Dr.**
  **W-6800 Mannheim 1 (DE)**
- **Funhoff, Angelika, Dr.**
  **W-6900 Heidelberg (DE)**

(56) Entgegenhaltungen:
**EP-A- 0 297 443**
**EP-A- 0 329 610**
**DE-A- 3 813 722**
**DE-A- 4 111 060**
**DE-A- 4 124 426**

- **PATENT ABSTRACTS OF JAPAN vol. 10, no. 374 (P-527)12. Dezember 1986 & JP-A-61 166 544 ( FUJI PHOTO FILM CO., LTD., ) 28. Juli 1986**
- **PATENT ABSTRACTS OF JAPAN vol. 14, no. 313 (P-1072)5. Juli 1990 & JP-A-21 00 055 ( FUJI PHOTO FILM CO., LTD., ) 12. April 1990**

Bemerkungen:
Die Akte enthält technische Angaben, die nach dem Eingang der Anmeldung eingereicht wurden und die nicht in dieser Patentschrift enthalten sind.



Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

Printed by Jouve, 75001 PARIS (FR)

## Beschreibung

Die Erfindung betrifft ein Verfahren zur Herstellung von Reliefmustern in einem positiv arbeitenden Einlagenphotoresist auf organischer Basis unter Verwendung strahlungsempfindlicher Gemische, die säurelabile Gruppierungen und photoaktive Komponenten enthalten, sensitiv gegenüber UV-, Elektronen- und Röntgenstrahlen sind und einen verbesserten Verarbeitungsspielraum aufweisen.

Positiv arbeitende strahlungsempfindliche Gemische sind bekannt. Positiv arbeitende Resistmaterialien, die o-Chinondiazide in wäßrig alkalischen Bindemitteln, z.B. Novolake enthalten, werden kommerziell als Photoresiste eingesetzt, so daß auch die Verfahren zur Herstellung von Reliefbildern bekannt sind. Die Empfindlichkeit dieser Systeme gegenüber Strahlung ist jedoch teilweise unbefriedigend.

Daher hat man strahlungsempfindliche Systeme entwickelt, welche in der Primärphotoreaktion eine Spezies erzeugen, die dann unabhängig von der Strahlung eine katalytische Sekundärreaktion auslösen und dadurch die Empfindlichkeiten drastisch erhöhen. Solche Systeme, die photochemisch eine starke Säure erzeugen, die dann in einer Sekundärreaktion säurelabile Gruppen spalten, sind z.B. aus US-PS 3 923 514, US-PS 3 915 706 und DE-A 34 06 927 bekannt.

Als solche photochemisch säureerzeugenden Verbindungen sind beispielsweise Oniumsalze, Halogenverbindungen, Nitrobenzylsulfonate, Sulfonsäureester von Phenolen und Disulfone [Makromolekular Chem., Rapid Communications, 4(8), 539-41 (1983)] bekannt. Die beschriebenen Disulfone werden zur Photovernetzung von epoxidhaltigen Polymeren eingesetzt. Des weiteren werden in JO 2100 055A unter anderem Disulfone in positiv-arbeitenden photoempfindlichen Zusammensetzungen in Kombination mit alkalilöslichen Bindemitteln erwähnt. Diese Gemische arbeiten nicht nach dem Prinzip der katalytischen Reaktionen und enthalten keine säurelabilen Gruppen. Weiterhin werden in DE-A 3,804,533 Disulfone als photochemische Säurespender zur Abspaltung von säurelabilen Silylgruppen beschrieben. Die dort beschriebenen strahlungsempfindlichen Verbindungen sind besonders für Mehrlagenresisttechniken geeignet, in der Einlagentechnik, bei der das Entfernen des Resists in der Regel im Sauerstoffplasma erfolgt, jedoch unerwünscht, da das enthaltene Silizium ein im Sauerstoffplasma nicht entfernbares Oxid bildet.

Für die Einlagentechnik werden daher besonders Resistsysteme auf rein organischer Basis, d.h. ohne Metall- und "refraktive Oxide bildende" Atome, wie Silizium, Germanium, Titan etc., gewünscht. Solche Systeme sind beschrieben und basieren beispielsweise auf säurelabile Carbonatgruppen enthaltenden Polymeren und Oniumsalzen oder organischen Verbindungen als photochemische Säurespender. Diese Systeme haben allerdings den Nachteil, daß sie sehr empfindlich auf geringste basische Verunreinigungen der Umgebungsluft reagieren und damit einen sehr eingeschränkten Verarbeitungsspielraum aufweisen, wie auf der SPIE Konferenz 4/5. März 1991, Symposium on Microlithography, San Jose, CA, USA, Publikation [1466-01] "Airborne chemical contamination of a chemically amplified resist" und [1466-02] "Preliminary lithographic characteristics of an all-organic chemically amplified resist formulation for single layer deep-UV lithography" geschildert. Beide Artikel beschreiben einen eingeengten Verarbeitungsspielraum, im letzteren zeigt die Lagerung bis zu 15 Minuten nach der Belichtung schon nicht mehr verwendbare Resistprofile.

Weiterhin werden in der DE-A 3 721 741 strahlungsempfindliche Gemische vorgeschlagen, die ein in wäßrigalkalischen Lösungen lösliches polymeres Bindemittel enthalten sowie eine organische Verbindung, deren Löslichkeit in einem wäßrig alkalischen Entwickler durch Einwirkung von Säure erhöht wird und die mindestens eine durch Säure spaltbare Gruppierung enthält, wobei diese organische Verbindung unter Einwirkung von Strahlung eine starke Säure erzeugt. Auch diese Gemische zeigen einen eingeschränkten Verarbeitungsspielraum, insbesondere wenn die Umgebungsluft Verunreinigungen, z.B. Basen, enthält.

Der Nachteil aller dieser Systeme ist deren Empfindlichkeit gegenüber Lagerzeiten, insbesondere zwischen dem Verfahrensschritt Belichtung und dem darauf folgendem Prozeß der Sekundärreaktion zur Abspaltung der säurelabilen Gruppen, die meist durch Ausheizen unterstützt wird. Lagerzeiten zwischen den Prozeßschritten "Belichtung" und "Ausheizen nach der Belichtung" führen im allgemeinen zu verlängerten Entwicklungszeiten bzw. nichtentwickelbaren Restschichten.

Aufgabe der vorliegenden Erfindung war es, ein Verfahren zur Herstellung von Reliefmustern in einem positiv arbeitenden Einlagenphotoresist auf organischer Basis unter Verwendung strahlungsempfindlicher Gemische, enthaltend säurelabile organische Gruppierungen und organische photochemische Säurespender aufzuzeigen, wobei ein praxisgerechter Verarbeitungsspielraum, insbesondere in bezug auf Lagerzeiten zwischen Belichtung und Ausheizschritten ermöglicht wird.

Diese Aufgabe läßt sich durch das erfindungsgemäße Verfahren sehr vorteilhaft lösen.

Gegenstand der Erfindung ist ein Verfahren zur Herstellung von Reliefmustern in einem positiv arbeitendem Einlagenphotoresist auf organischer Basis, das keine Metallatome und keine refraktive Oxide bildenden Atome enthält, enthaltend eine Mischung aus

(a1) einem säurelabilen Ether-, Ester- oder Carbonatgruppen enthaltenden, in Wasser unlöslichem organischem Bindemittel, das durch Einwirkung von Säure in wässrig-alkalischen Lösungen löslich wird,

oder eine Zusammensetzung aus

(a2) einen in Wasser unlöslichen, in wässrig-alkalischen Lösungen löslichem polymeren Bindemittel und

(a2.1) einer organischen Verbindung, deren Löslichkeit in einem wässrig-alkalischen Entwickler durch Einwirkung von Säure erhöht wird, oder

(a2.2) einer organischen Verbindung, deren Löslichkeit in einem wässrig-alkalischen Entwickler durch Einwirkung von Säure erhöht wird und die mindestens eine durch Säure spaltbare Gruppierung sowie zusätzlich eine Gruppierung, die unter Einwirkung von Strahlung eine starke Säure bildet, enthält
oder ein Gemisch der organischen Verbindungen (a2.1) und (a2.2)

und

(b) zusätzlich einer organische Verbindung, welche unter Einwirkung von Strahlung eine starke Säure erzeugt,

durch schichtförmiges Auftragen der Mischung auf einen oberflächlich oxidierten Siliziumwafer, bildmässige Bestrahlung der Aufzeichnungsschicht mit kurzwelligen UV-, Elektronen- oder Röntgenstrahlen in solcher Dosis, daß die Löslichkeit der belichteten Bereiche in wässrigalkalischen Lösungen zunimmt und diese Bereiche selektiv mit einem wässrig-alkalischen Entwickler entfernt werden können, thermisches Ausheizen der bildmässig belichteten Aufzeichnungsschicht bei Temperaturen zwischen 60 und 120°C und selektives Entfernen der belichteten Bereiche der Aufzeichnungsschicht mit einem wässrig-alkalischen Entwickler, dadurch gekennzeichnet, daß man zur Vergrösserung des Verarbeitungsspielraums und der Lagerzeit zwischen den Verfahrensschritten der bildmässiger Belichtung und dem Ausheizen und Entwickeln der Aufzeichnungsschicht als organische Verbindung (b) Disulfone der Formel (I)

$$R^1 - SO_2 - SO_2 - R^2 \qquad (I)$$

verwendet, worin $R^1$ und $R^2$ untereinander gleich oder verschieden sind und für Alkyl, Cycloalkyl, Aryl, Aralkyl oder Heteroaryl mit bis zu 12 Kohlenstoffatomen oder durch Alkyl, Alkoxy, Halogen, Nitro, Alkylthio, Alkanoyl, Alkoxycarbonyl, Arylthio, Alkylsulfoxy, Alkylsulfonyl, Aryloxy, Arylsulfoxy, Arylsulfonyl mit jeweils bis zu 6 Kohlenstoffatomen ein- oder mehrfach substituiertes Alkyl, Cycloalkyl, Aryl, Aralkyl oder Heteroaryl mit bis zu 12 Kohlenstoffatomen stehen.

Als säurelabile Ether-, Ester- oder Carbonatgruppen bevorzugt sind tert.-Alkylcarbonate von Phenolen, tert.-Butylester von Carbonsäuren, t-Butylether von Phenolen und/oder Tetrahydropyranylether von Phenolen.

Als säurelabile Carbonatgruppen enthaltendes organisches Bindemittel (a1) bevorzugt sind insbesondere Poly-p-tert.-butoxycarbonyloxystyrol oder ein Copolymerisat des p-tert.-Butoxycarbonyloxystyrols, als säurelabile Estergruppen enthaltendes organisches Bindemittel (a1) Poly-(tert.-butylmethacrylat) oder ein Copolymerisat des tert.-Butylmethacrylats, als säurelabile Ethergruppen enthaltendes organisches Bindemittel (a1) Poly(tetrahydropyranyloxystyrol) oder ein Copolymerisat des Tetrahydropyranyloxystyrols.

Bevorzugte Beispiele für in Wasser unlösliche, in wäßrig-alkalischen Lösungen lösliche polymere Bindemittel (a2) sind Poly-(p-hydroxystyrol), Poly-(p-hydroxy-α-methylstyrol), Copolymere von p-Hydroxy-(α-methyl)styrol mit t-Butoxycarbonyloxystyrol, t-Amylcarbonyloxystyrol, t-Butoxystyrol, t-Butylmethacrylat, Tetrahydropyranyloxystyrol, 2-Methylhydroxystyrol und/oder 2,6-Dimethylhydroxystyrol, wobei der Anteil der Comonomeren so gewählt wird, daß die Bindemittel in einem wäßrig-alkalischen Lösungsmittel geeigneten pH-Wertes löslich sind.

Als organische Verbindungen (b) werden vorzugsweise Diaryldisulfone eingesetzt, wobei Phenyl-(4-Anisyl)-disulfon, Bis-(phenyl)-disulfon und Bis-(4-Anisyl)-disulfon besonders bevorzugt sind.

Die erfindungsgemäßen strahlungsempfindlichen Gemische ermöglichen überraschenderweise die Herstellung von Reliefmustern und Reliefbildern mit hoher Auflösung bei praxisgerechter Verarbeitbarkeit mit genügend großem Verarbeitungsspielraum, insbesondere mit tolerierbaren Lagerzeiten zwischen Belichtung und Ausheizschritt > 15 Minuten.

Weiterhin ist die Empfindlichkeit der Systeme durch die katalytische Wirkung der photochemisch erzeugten Säuren sehr hoch, und es ergeben sich sehr hohe Kontrastwerte. Diese strahlungsempfindlichen Gemische sind daher für die Anwendung in der Deep-UV Lithographie sehr gut geeignet.

Zu den Aufbaukomponenten des erfindungsgemäßen strahlungsempfindlichen Gemisches ist im einzelnen folgendes auszuführen.

(a1) Als säurelabile Ether-, Ester- oder Carbonatgruppen enthaltende, in Wasser unlösliche organische Bindemittel

(a1), die durch Einwirkung von Säure in wäßrig-alkalischen Lösungen löslich werden, kommen Polymere auf Basis von Homo- oder Copolymeren des p-t-Butoxystyrols, p-t-Butoxycarbonyloxystyrols, t-Amylcarbonyloxystyrols oder p-Tetrahydropyranyloxystyrols, als Comonomereinheiten kommen dabei alle mit Styrol copolymerisierbaren Monomeren, beispielsweise Acrylate, Methacrylate, Styrol und dessen Derivate, Schwefeldioxid, Maleinimide, insbesondere jedoch p-Hydroxistyrol und/oder p-Hydroxy-α-methylstyrol und in o-Stellung zur OH-Gruppe mono- oder disubstituierte Hydroxistyrole in Betracht; bevorzugt sind Poly-(p-t-butoxycarbonyloxy)styrol, Poly-(p-t-butoxystyrol) und Poly-(p-(tetrahydropyranyl)oxystyrol),
Das polymere Bindemittel (a1) ist im erfindungsgemäßen Gemisch im allgemeinen in einer Menge von 55 bis 99,5, vorzugsweise 70 bis 99 Gew.-%, bezogen auf die Summe der Komponenten (a1) und (b) enthalten.

(a2) Als in Wasser unlösliche, in wäßrig-alkalischen Lösungen lösliche polymere Bindemittel (a2) kommen Polymere auf Basis von Homo- oder Copolymeren des p-Hydroxistyrols und/oder p-Hydroxi-α-methylstyrols in Betracht, wobei als Comonomereinheiten besonders in o-Stellung zur Hydroxygruppe mono- oder disubstituierte Hydroxistyrole oder Hydroxistyrole, deren phenolische Gruppe mit säurelabilen Gruppierungen geschützt ist, in Frage kommen. Besonders bevorzugte säurelabile Gruppierungen sind dabei t-Alkylcarbonate, wie t-Butylcarbonate, t-Amylcarbonate, Ether und Acetale, wie t-Butylether und Tetrahydropyranylether sowie t-Butylester. Die Comonomereinheiten sind dabei nur in solchen Mengen vorhanden, daß das Polymere wäßrig alkalisch löslich ist, bevorzugt im Bereich von 10 bis 70 Mol%.

Die Polymeren (a1) bzw. (a2) weisen im allgemeinen mittlere Molekulargewichte $\overline{M}w$ zwischen 2 000 und 100 000, vorzugsweise zwischen 8 000 und 30 000 auf.

Als organische Verbindungen (a2.1), welche säurelabile Gruppen, bevorzugt t-Alkylether, t-Alkylester, Acetale, Tetrahydropyranylether oder t-Alkylcarbonate enthalten, seien hier beispielhaft aufgeführt:

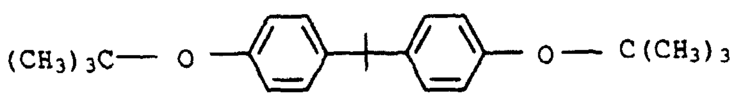 ,

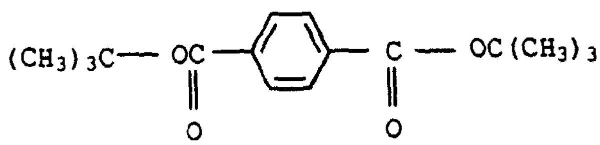 ,

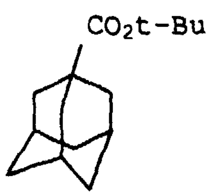 ,

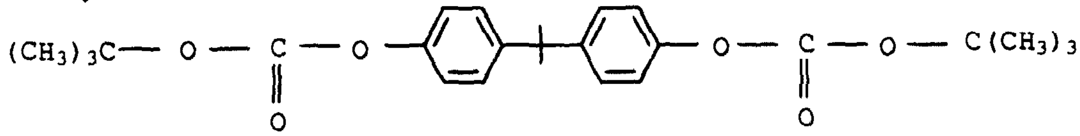 ,

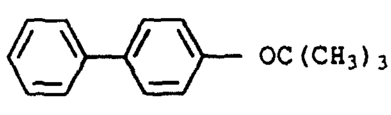 , 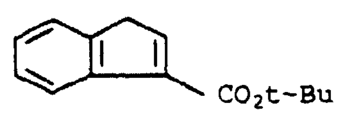 ,

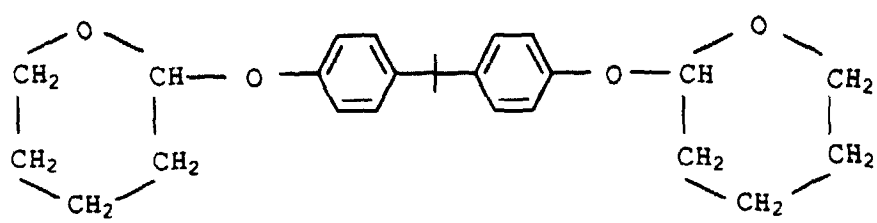

und

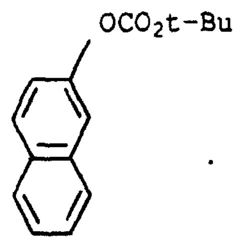

.

Als organische Verbindungen (a2.2), deren Löslichkeit in einem wäßrig-alkalischen Entwickler durch Einwirkung von Säure erhöht wird und die mindestens eine durch Säure spaltbare Gruppierung sowie zusätzlich eine Gruppierung, die unter Einwirkung von Strahlung eine starke Säure bildet, enthält, kommen insbesondere Oniumsalze, enthaltend säurelabile Gruppierungen, wie sie in US-A 4 883 740 beschrieben sind, in Frage.

Besonders bevorzugte organische Verbindungen (a 2.2) sind solche der allgemeinen Formel (II)

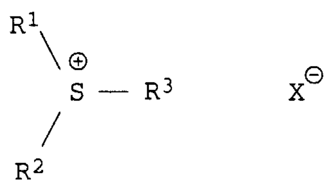

(II)

worin $R^1$, $R^2$ und $R^3$ untereinander gleich oder verschieden sind und für aliphatische und/oder aromatische Reste, die gegebenenfalls Heteroatome enthalten, stehen oder zwei der Reste $R^1$ bis $R^3$ miteinander zu einem Ring verknüpft sind, mit der Maßgabe, daß mindestens einer der Reste $R^1$ bis $R^3$ mindestens eine durch Säure spaltbare Gruppierung, vorzugsweise t-Butylcarbonate von Phenolen bzw. t-Alkyl-ether von Phenolen enthält, wobei einer der Reste $R^1$ bis $R^3$ mit einem oder mehreren weiteren Sulfoniumsalzresten, gegebenenfalls über durch Säure spaltbare Gruppierungen, verknpft sein kann und $X^{\ominus}$ ein nichtnucleophiles Gegenion bedeutet.

Als Gegenion kommen bevorzugt starke organische Säureanionen wie Tosylat, Mesylat, Benzolsulfonat, Trifluormethansulfonat und Fluorsulfonat, in Frage.

b) Als organische Verbindungen (b) werden erfindungsgemäß 1,2-Disulfone der allgemeinen Formel (I)

$$R^1\text{-}SO_2\text{-}SO_2\text{-}R^2 \qquad (I)$$

worin $R^1$ und $R^2$ untereinander gleich oder verschieden sind und für bis zu 12 Kohlenstoffatome enthaltendes Alkyl, wie z.B. Methyl, Ethyl, Butyl, Cycloalkyl, wie z.B. Cyclohexyl, Aryl, wie z.B. Phenyl, Aralkyl, wie z.B. Benzyl oder Heteroaryl, wie z.B. ein Thiophenrest oder durch 1 bis 6 Kohlenstoffatome enthaltendes Alkyl, wie z.B. Methyl, t-Butyl, Propyl, Alkoxy, wie z.B. Methoxy, Butoxy, Halogen, wie z.B. F, Cl oder Br, Nitro, Alkylthio, wie z.B. Methylthio, Alkanoyl, Alkoxycarbonyl, wie z.B. Methoxycarbonyl, Arylthio, wie z.B. Phenylthio, $C_1$-$C_6$-Alkylsulfoxy, $C_1$-$C_6$-Alkylsulfonyl, wie z.B. Toluylsulfonyl, Aryloxy, wie z.B. Phenoxy, Arylsulfoxy, wie z.B. Phenylsulfoxy oder Arylsufonyl, wie z.B. Phenylsulfonyl, ein- oder mehrfach substituiertes Alkyl, Cycloalkyl, Aryl, wie z.B. Tolyl, Anisyl, Chlorphenyl,

Bromphenyl, 2,4,6-Trimethylphenyl, Aralkyl oder Heteroaryl mit bis zu 12 Kohlenstoffatomen stehen.

Die organischen Verbindungen (b) der allgemeinen Formel (I) enthaltend Arylreste als $R^1$ und/oder $R^2$ werden besonders bevorzugt als photochemische Säurespender im kurzwelligen (Deep)-UV-Bereich eingesetzt. Besonders geeignet sind Phenyl, Tolyl und Anisyl als $R^1$ und/oder $R^2$ der allgemeinen Formel (I).

Die organischen Verbindungen (b) der Formel (I) können alle im Prinzip nach Verfahren hergestellt werden wie sie in der Literatur bereits beschrieben sind, beispielsweise in DE-A 3 804 316.

Die organischen Verbindungen (b) sind im erfindungsgemäßen Gemisch in Kombination mit Bindemittel (a1) in einer Menge von 0,5 bis 45 Gew.-%, bevorzugt 1 bis 30 Gew.-%, enthalten, bezogen auf die Summe der Komponenten (a1) und (b).

Für den Fall von erfindungsgemäßen Gemischen der Komponenten (a2), (a2.1) und (b) ist die Komponente (a2) vorzugsweise in Mengen von 90 - 40 Gew.-%, die Komponente (a2.1) in Mengen von 9 bis 40 Gew.-% und die Komponente (b) in Mengen von 1 bis 20 Gew.-%, bezogen auf die Gesamtmenge der Komponenten (a2) + (a2.1) + (b) enthalten.

Für den Fall von Gemischen der Komponenten (a2), (a2.1) und/oder (a2.2) und (b) sind diese vorzugsweise in Mengen von 97 bis 60 Gew.-% (a2), 1 bis 20 Gew.-% (a2.1), 1 bis 20 Gew.-% (a2.2) und 1 bis 20 Gew.-% (b), bezogen auf die Gesamtmenge dieser Komponenten enthalten, mit der Maßgabe, daß die Summe der Prozentzahlen jeweils gleich 100 ist, und wobei die Komponenten (a2.1) und (a2.2) sich gegenseitig ersetzen können.

Die erfindungsgemäßen Gemische werden zur Herstellung von Resists, für Reliefmuster bevorzugt in einem organischen Lösungsmittel gelöst, wobei der Feststoffgehalt üblicherweise im Bereich zwischen 5 und 40 Gew.-% liegt. Als Lösungsmittel kommen bevorzugt aliphatische Ketone, Ether und Ester, sowie Mischungen derselben in Frage. Besonders bevorzugt sind Alkylenglykolmonoalkylether, wie beispielsweise Ethyl-cellosolve, Butylglykol, Methyl-cellosolve und 1-Methoxy-2-propanol, Alkylenglykolalkylether-ester, wie beispielsweise Methyl-cellosolve-acetat, Methyl-propylenglykol-acetat, und Ethyl-propylenglykol-acetat und Ketone, wie beispielsweise Cyclohexanon, Cyclopentanon und Methylethylketon, sowie Acetate, wie Butylacetat und Aromaten, wie Toluol und Xylol sowie Ethylacetat und Diacetonalkohol. Die Auswahl der entsprechenden Lösungsmittel, sowie deren Mischungen richtet sich nach der Wahl des jeweiligen Polymers und der photoaktiven Komponente.

Weiterhin können dem erfindungsgemäßen Gemisch andere Zusätze wie Haftvermittler, Netzmittel, Farbstoffe und Weichmacher zugesetzt werden.

Gegebenenfalls können auch Sensibilisatoren in geringen Mengen zugesetzt werden, um die Verbindungen im längerwelligen UV- bis hin zum sichtbaren Bereich zu sensibilisieren. Polycyclische Aromaten, wie Pyren und Perylen sind dafür bevorzugt, jedoch können auch andere Farbstoffe, die als Sensibilisatoren wirken, verwendet werden.

Beim erfindungsgemäßen Verfahren zur Herstellung von Reliefmustern wird in üblicher Weise eine strahlungsempfindliche Aufzeichnungsschicht, die im wesentlichen aus dem erfindungsgemäßen strahlungsempfindlichen Gemisch besteht, bildmäßig in solcher Dosis bestrahlt, daß die Löslichkeit der belichteten Bereiche, gegebenenfalls nach einem thermischen Ausheizschritt bei Temperaturen zwischen 60°C und 120°C, in wäßrig alkalischen Lösungsmitteln zunimmt und diese Bereiche selektiv mit dem alkalischen Entwickler entfernt werden können.

Vorzugsweise werden z.B. das polymere Bindemittel mit säurelabilen Gruppierungen und 1 - 10 % eines erfindungsgemäßen Disulfons (b), bezogen auf den Feststoffgehalt des strahlungsempfindlichen Gemisches, in Methoxypropylacetat gelöst, wobei der Feststoffgehalt zwischen 10 und 30 Gew.-% liegt. Die Lösung kann durch ein Filter mit der Porenweite von 0,2 µm filtriert werden. Durch Aufschleudern der Resistlösung bei Umdrehungszahlen zwischen 1 000 und 10 000 U/min wird ein Resistfilm in einer Schichtdicke von 0,5 bis 2 µm auf einem oberflächenoxidierten Siliziumwafer erzeugt. Der Wafer wird dann zur Trocknung zwischen 1 min und 5 min bei ca. 90°C ausgeheizt. Die Filme werden dann durch eine chrombeschichtete strukturierte Quarzmaske mit UV-Licht einer Quecksilber-Hochdrucklampe, mit Excimer-Laserlicht, Elektronen- oder Röntgenstrahlen bildmäßig bestrahlt. Die bestrahlten Filme werden danach mit alkalischen oder alkoholischen Entwicklern entwickelt oder gegebenenfalls vorher zwischen 5 Sekunden und 5 min bei Temperaturen zwischen 60°C und 120°C ausgeheizt. Das erfindungsgemäße Verfahren zeichnet sich insbesondere dadurch aus, daß man Lagerzeiten in normaler Umgebungsluft größer 15 Minuten zwischen den Verfahrensschritten "Belichtung" und "Ausheizen nach der Belichtung" tolerieren kann ohne an Leistungsfähigkeit, d.h. Sensitivität und Strukturgüte, einzubüßen.

Die in den Beispielen genannten Teile und Prozente sind, soweit nicht anders angegeben Gewichtsteile bzw. Gewichtsprozente.

Beispiel 1

Eine Photoresistlösung wird aus 6 Teilen Phenyl-(4-Anisyl)disulfon, 94 Teilen Poly-(p-vinylphenol-co-p-t-butoxicarbonyloxistyrol (molares Verhältnis der Comonomeren 3:7)), und 300 Teilen Methoxypropylacetat hergestellt.

Die Lösung wird anschließend durch ein Filter mit einem Porendurchmesser von 0,2 µm filtriert.

Diese Resistlösung wird auf einem oberflächlich oxidierten Siliziumwafer in einer Schichtdicke von ca. 1 µm aufgebracht und 1 Minute bei 90°C auf einer Hotplate ausgeheizt. Dann belichtet man bildmäßig durch eine strukturierte Testmaske im Kontaktverfahren während 4 Sekunden mit Excimer-Laserlicht der Wellenlänge 248 nm.

Nach dem Belichten wird die eine Hälfte des Wafers sofort 1 Minute bei 90°C ausgeheizt und mit einem alkalischen Entwickler entwickelt. Nach 28 Sekunden Entwicklungszeit sind die mit 70 mJ/cm$^2$ belichteten Bereiche vollständig abgetragen.

Die andere Hälfte des Wafers wird 120 Minuten nach der Belichtung in normaler Raumluft liegengelassen, dann 1 Minute 90°C ausgeheizt und entwickelt. Die Entwicklungszeit beträgt ebenfalls 28 Sekunden.

Vergleichsbeispiel 1

Es wird eine Resistformulierung wie in Beispiel 1 verwendet, jedoch enthält die Resistformulierung 6 Teile Tris-(t-butoxycarbonyloxyphenyl)sulfonium trifluormethansulfonat anstatt des Disulfons. Es wird wie in Beispiel 1 beschichtet, ausgeheizt und belichtet. Die eine Hälfte des Wafers wird sofort ausgeheizt. Dabei beträgt die Entwicklungszeit bei 70 mJ/cm$^2$ Belichtung 30 Sekunden. Die andere Hälfte des Wafers bleibt 120 Minuten nach Belichtung in normaler Raumluft liegen und wird erst dann 1 Minute bei 90°C ausgeheizt. Es lassen sich keine Resistmuster mehr entwickeln.

Beispiel 2

Eine Photoresistlösung wird aus 15 Teilen Tris-(4-t-butoxicarbonyloxiphenyl-)sulfonium trifluormethansulfonat, 5 Teilen Diphenyl-disulfon, 80 Teilen Poly-(p-vinylphenol) und 300 Teilen Methyl-propylenglykolacetat hergestellt. Die Lösung wird anschließend durch ein Filter mit einem Porendurchmesser von 0,2 µm filtriert.

Dieses Resistlösung wird auf einen Siliziumwafer mit einem $SiO_2$-Film in einer Schichtdicke von ca. 1 µm aufgeschleudert. Der Wafer wird eine Minute bei 90°C getrocknet, anschließend mit einer bildmäßig strukturierten Testmaske in Kontakt gebracht und mit 30 mJ/cm$^2$ mit Excimer-Laserlicht der Wellenlänge 248 nm belichtet.

Dann läßt man den Wafer 1 Stunde liegen (21°C, rel. Raumfeuchte 45 %), um eventuell auftretende Wartezeiten zwischen den einzelnen Prozeßschritten zu simulieren.

Anschließend wird der Wafer 1 Minute bei 90°C ausgeheizt und mit einem alkalischen Entwickler entwickelt. Der Wafer läßt sich einwandfrei zu einem positiven Reliefmuster entwickeln und zeigt die gleiche Strukturgüte wie ein Vergleichswafer der direkt nach der Belichtung ausgeheizt wurde.

Vergleichsbeispiel 2

Es wird wie in Beispiel 1 verfahren, jedoch enthält die Resistlösung kein Disulfon, stattdessen 85 % Polymer. Nach einer Stunde Lagerzeit zwischen Belichtung und Ausheizen ist das Resistmuster mit dem gleichen Entwickler nicht mehr entwickelbar.

Beispiel 3

Es wird wie in Beispiel 1 verfahren, jedoch wird anstatt des Phenyl-(4-Anisyl)-disulfons das Diphenyl-disulfon eingesetzt. Die Entwicklungsergebnisse sind exakt identisch mit denen des Beispiels 1.

Beispiel 4

Eine Photoresistlösung wird aus 6 Teilen Phenyl-(4-Anisyl)-disulfon, 94 Teilen Poly-(p-t-butoxicarbonyloxistyrol), und 300 Teilen Methoxypropylacetat hergestellt. Die Lösung wird anschließend durch ein Filter mit einem Porendurchmesser von 0,2 µm filtriert.

Diese Resistlösung wird auf einem Siliziumwafer in einer Schichtdicke von ca. 1 µm aufgebracht und 1 Minute bei 90°C auf einer Hotplate ausgeheizt. Dann belichtet man bildmäßig durch eine strukturierte Testmaske im Kontaktverfahren während 4 Sekunden mit Excimer-Laserlicht der Wellenlänge 248 nm.

Nach dem Belichten wird die eine Hälfte des Wafers sofort 1 Minute 90°C ausgeheizt und mit einem alkalischen Entwickler entwickelt. Nach 35 Sekunden Entwicklungszeit sind die mit 30 mJ/cm$^2$ belichteten Bereiche vollständig abgetragen.

Die andere Hälfte des Wafers wird 30 Minuten nach der Belichtung in normaler Raumluft liegengelassen, dann 1 Minute bei 90°C ausgeheizt und entwickelt. Die Entwicklungszeit beträgt ebenfalls 35 Sekunden.

Beispiel 5

Es wird eine Photoresistlösung aus 10 Teilen Bis-(4-Anisyl)-disulfon, 90 Teilen Poly-(vinylphenol-co-p-t-amyloxycarbonyloxi-styrol) (molares Verhältnis der Comonomeren: 8 : 2) und 300 Teilen Ethyllactat hergestellt und durch ein Filter mit einer Porenweite von 0,2 µm filtriert.
Die Restistlösung wird in einer Schichtdicke von ca. 1 µm auf einen Wafer aufgebracht und bildmäßig belichtet. Man kann anschließend bis zu 20 Minuten lagern, ohne daß sich das Entwicklungsverhalten ändert, während ein Vergleichswafer ohne Disulfon, stattdessen mit Dimethyl-(t-butoxycarbonyloxyphenyl)sulfonium-triflat, innerhalb der Entwicklungszeit von 60 Sekunden nicht mehr durchentwickelt werden kann.

**Patentansprüche**

1. Verfahren zur Herstellung von Reliefmustern in einem positiv arbeitendem Einlagenphotoresist auf organischer Basis, das keine Metallatome und keine refraktive Oxide bildenden Atome enthält, enthaltend eine Mischung aus

   (a1) einem säurelabilen Ether-, Ester- oder Carbonatgruppen enthaltenden, in Wasser unlöslichem organischem Bindemittel, das durch Einwirkung von Säure in wässrig-alkalischen Lösungen löslich wird,
   der eine zusammensetzung aus

   (a2) einen in Wasser unlöslichen, in wässrig-alkalischen Lösungen löslichem polymeren Bindemittel und

      (a2.1) einer organischen Verbindung, deren Löslichkeit in einem wässrig-alkalischen Entwickler durch Einwirkung von Säure erhöht wird, oder

      (a2.2) einer organischen Verbindung, deren Löslichkeit in einem wässrig-alkalischen Entwickler durch Einwirkung von Säure erhöht wird und die mindestens eine durch Säure spaltbare Gruppierung sowie zusätzlich eine Gruppierung, die unter Einwirkung von Strahlung eine starke Säure bildet, enthält
      oder ein Gemisch der organischen Verbindungen (a2.1) und (a2.2)

   und

   (b) zusätzlich einer organischen Verbindung, welche unter Einwirkung von Strahlung eine starke Säure erzeugt,

   durch schichtförmiges Auftragen der Mischung auf einen oberflächlich oxidierten Siliziumwafer, bildmässige Bestrahlung der Aufzeichnungsschicht mit kurzwelligen UV-, Elektronen- oder Röntgenstrahlen in solcher Dosis, daß die Löslichkeit der belichteten Bereiche in wässrigalkalischen Lösungen zunimmt und diese Bereiche selektiv mit einem wässrig-alkalischen Entwickler entfernt werden können, thermisches Ausheizen der bildmässig belichteten Aufzeichnungsschicht bei Temperaturen zwischen 60 und 120°C und selektives Entfernen der belichteten Bereiche der Aufzeichnungsschicht mit einem wässrig-alkalischen Entwickler, dadurch gekennzeichnet, daß man zur Vergrösserung des Verarbeitungsspielraums und der Lagerzeit zwischen den Verfahrensschritten der bildmässiger Belichtung und dem Ausheizen und Entwickeln der Aufzeichnungsschicht als organische Verbindung (b) Disulfone der Formel (I)

   $$R^1 - SO_2 - SO_2 - R^2 \qquad (I)$$

   verwendet, worin $R^1$ und $R^2$ untereinander gleich oder verschieden sind und für Alkyl, Cycloalkyl, Aryl, Aralkyl oder Heteroaryl mit bis zu 12 Kohlenstoffatomen oder durch Alkyl, Alkoxy, Halogen, Nitro, Alkylthio, Alkanoyl, Alkoxycarbonyl, Arylthio, Alkylsulfoxy, Alkylsulfonyl, Aryloxy, Arylsulfoxy, Arylsulfonyl mit jeweils bis zu 6 Kohlenstoffatomen ein- oder mehrfach substituiertes Alkyl, Cycloalkyl, Aryl, Aralkyl oder Heteroaryl mit bis zu 12 Kohlenstoffatomen stehen.

2. Verfahren nach Anspruch 1, dadurch gekennzeichnet, daß im Bindemittel (a1) als säurelabile Ether-, Ester- oder Carbonatgruppen tert. Alkylcarbonate von Phenolen, tert.Butylester von Carbonsäuren, tert.Butylether von Phenolen und/oder Tetrahydropyranether von Phenolen eingesetzt werden.

**3.** Verfahren nach einem der Ansprüche 1 bis 3, dadurch gekennzeichnet, daß als säurelabile Carbonatgruppen enthaltendes Bindemittel (a1) Poly-p-tert.butoxycarbonyloxystyrol oder ein Copolymerisat des p-tert. Butoxycarbonyloxylstyrol eingesetzt wird.

**4.** Verfahren nach einem der Ansprüche 1 bis 4, dadurch gekennzeichnet, daß als organische Verbindung (b) ein Diaryldisulfon eingesetzt wird.

**5.** Verfahren nach einem der Ansprüche 1 bis 5, dadurch gekennzeichnet, daß die Mischung der Aufzeichnungsschicht als Verbindung (a2.2) ein Sulfoniumsalz enthält.

**6.** Verfahren nach einem der Ansprüche 1 bis 6, dadurch gekennzeichnet, daß die Mischung der Aufzeichnungsschicht als Bindemittel (a2) ein Poly(p-hydroxystyrol), Poly(p-hydroxy-α-methylstyrol) oder ein Copolymer von p-Hydroxystyrol oder von p-Hydroxy-α-methylstyrol mit einem mittleren Molekulargewicht $M_w$ von 2000 bis 100 000 enthält.

**Claims**

**1.** A process for the production of relief patterns in a positive-working single-layer photoresist on an organic basis which contains no metal atoms and no atoms which form refractive oxides, containing a mixture of

(a1) an organic binder which contains acid-labile ether, ester or carbonate groups, is insoluble in water and becomes soluble in aqueous alkaline solutions as a result of the action of an acid,
or a composition consisting of

(a2) a polymeric binder which is insoluble in water but soluble in aqueous alkaline solutions and
(a2.1) an organic compound whose solubility in an aqueous alkaline developer is increased by the action of an acid, or
(a2.2) an organic compound whose solubility in an aqueous alkaline developer is increased by the action of an acid and which contains one or more groups cleavable by acid and in addition a group which forms a strong acid under the action of radiation,
or a mixture of organic compounds (a2.1) and (a2.2)

and
(b) additionally an organic compound which produces a strong acid under the action of radiation, by application of the mixture in the form of a layer to a superficially oxidized silicon wafer, imagewise exposure of the recording layer to short-wave UV radiation, electron beams or X-rays in a dose such that the solubility of the exposed parts in aqueous alkaline solutions increases and these parts can be selectively removed with an aqueous alkaline developer, heating of the imagewise exposed recording layer at from 60 to 120°C and selective removal of the exposed parts of the recording layer with an aqueous alkaline developer, wherein, for increasing the processing latitude and the storage time between the process steps of imagewise exposure and the heating and development of the recording layer, the organic compound (b) used is a disulfone of the formula (I)

$$R^1 - SO_2 - SO_2 - R^2 \qquad (I)$$

where $R^1$ and $R^2$ are identical or different and are each alkyl, cycloalkyl, aryl, aralkyl or hetaryl of not more than 12 carbon atoms or are each alkyl, cycloalkyl, aryl, aralkyl or hetaryl of not more than 12 carbon atoms which is monosubstituted or polysubstituted by alkyl, alkoxy, halogen, nitro, alkylthio, alkanoyl, alkoxycarbonyl, arylthio, alkylsulfoxyl, alkylsulfonyl, aryloxy, arylsulfoxyl or arylsulfonyl, each of not more than 6 carbon atoms.

**2.** A process as claimed in claim 1, wherein tert-alkyl carbonates of phenols, tert-butyl esters of carboxylic acids, tert-butyl ethers of phenols or tetrahydropyran ethers of phenols are used as acid-labile ether, ester or carbonate groups in the binder (a1).

**3.** A process as claimed in claim 1 or 2, wherein poly-p-tert-butoxycarbonyloxystyrene or a copolymer of p-tert-butoxycarbonyloxystyrene is used as the binder (a1) containing acid-labile carbonate groups.

4. A process as claimed in any of claims 1 to 3, wherein a diaryl disulfone is used as the organic compound (b).

5. A process as claimed in any of claims 1 to 4, wherein the mixture of the recording layer contains a sulfonium salt as a compound (a2.2).

6. A process as claimed in any of claims 1 to 5, wherein the mixture of the recording layer contains a poly(p-hydroxystyrene), poly(p-hydroxy-α-methylstyrene) or a copolymer of p-hydroxystyrene or of p-hydroxy-α-methylstyrene having an average molecular weight $M_w$ of from 2000 to 100,000 as binder (a2).

**Revendications**

1. Procédé pour former des modèles en relief dans une photoréserve à une couche opérant en positif à base organique mais ne contenant aucun atome métallique ni atome formant des oxydes réfractants, qui contient un mélange de

   (a1) un liant organique insoluble dans l'eau contenant des groupes éther, ester ou carbonate instables aux acides, qui est rendu soluble dans les solutions aqueuses alcalines sous l'action d'un acide,
   ou bien une composition consistant en
   (a2) un liant palymère insoluble dans l'eau mais soluble dans les solutions aqueuses alcalines et

      (a2.1) un composé organique dont la solubilité dans un révélateur aqueux alcalin est accrue sous l'action d'un acide, ou bien
      (a2.2) un composé organique dont la solubilité dans un révélateur aqueux alcalin est accrue sous l'action d'un acide et qui contient au moins un groupement scindable par les acides et en outre un groupement qui forme un acide fort sous l'action du rayonnement

   ou un mélange des composés organiques (a2.1) et (a2.2) et
   (b) en outre un composé organique qui produit un acide fort sous l'action du rayonnement,

par application du mélange en couche sur une puce de silicium oxydée en surface, exposition de la couche d'enregistrement avec formation d'une image à la lumière UV à courte longueur d'onde, à des faisceaux d'électrons ou à des rayons X à une dose telle que la solubilité des régions exposées dans les solutions aqueuses alcalines augmente et que ces régions puissent être éliminées sélectivement par un révélateur aqueux alcalin, chauffage de la couche d'enregistrement exposée avec formation d'une image à des températures de 60 à 120°C et élimination sélective des régions exposées de la couche d'enregistrement à l'aide d'un révélateur aqueux alcalin, caractérisé par le fait que, pour agrandir l'intervalle dont on dispose pour le traitement et augmenter la durée de conservation entre les stades opératoires d'exposition avec formation d'une image et de chauffage et développement de la couche d'enregistrement, on utilise en tant que composé organique (b) une disulfone de formule I

$$R^1 - SO_2 - SO_2 - R^2 \qquad (I)$$

dans laquelle $R^1$ et $R^2$, ayant des significations identiques ou différentes, représentent chacun un groupe alkyle, cycloalkyle, aryle, aralkyle ou hétéroaryle contenant jusqu'à 12 atomes de carbone ou un groupe alkyle, cycloalkyle, aryle, aralkyle ou hétéroaryle contenant jusqu'à 12 atomes de carbone et portant un ou plusieurs substituants choisis parmi les groupes alkyle, alcoxy, les halogènes, les groupes nitro, alkylthio, alcanoyle, alcoxycarbonyle, arylthio, alkylsulfoxy, alkylsulfonyle, aryloxy, arylsulfoxy, arylsulfonyle contenant chacun jusqu'à 6 atomes de carbone.

2. Procédé selon la revendication 1, caractérisé par le fait que l'on utilise dans le liant (a1), en tant que composés organiques contenant des groupes éther, ester ou carbonate instables aux acides, des tert-alkylcarbonates de phénols, des esters tert-butyliques d'acides carboxyliques, des éthers tert-butyliques de phénols et/ou des éthers tétrahydropyrannyliques de phénols.

3. Procédé selon l'une des revendications 1 à 3, caractérisé par le fait que l'on utilise en tant que liant (a1) contenant des groupes carbonate instables aux acides un poly-p-tert-butoxycarbonyloxystyrène ou un copolymère du p-tert-butoxycarbonyloxy-styrène.

4. Procédé selon l'une des revendications 1 à 4, caractérisé par le fait que le composé organique (b) est une diaryldisulfone.

5. Procédé selon l'une des revendications 1 à 5, caractérisé par le fait que le mélange de la couche d'enregistrement contient en tant que composé (a2.2) un sel de sulfonium.

6. Procédé selon l'une des revendications 1 à 6, caractérisé par le fait que le mélange de la couche d'enregistrement contient en tant que liant (a2) un poly-(p-hydroxystyrène), un poly-(p-hydroxy-alpha-méthylstyrène) ou un copolymère du p-hydroxystyrène ou du p-hydroxy-alpha-méthylstyrène de poids moléculaire moyen $M_w$ compris entre 2000 et0 100 000.